# EUROPEAN PATENT APPLICATION

(11) **EP 2 485 222 A1**
(43) Date of publication of application: **08.08.2012**
(21) Application number: 10820496.7
(22) Date of filing: 28.09.2010
(51) Int. Cl.: H01B 13/00, C21D 6/00, C22C 38/00, C22C 38/58, H01B 12/06, H01F 6/06

(54) **SUBSTRATE FOR SUPERCONDUCTING WIRING, SUPERCONDUCTING WIRING AND PRODUCTION METHOD FOR SAME**

(30) Priority: 29.09.2009 JP 2009223795
(71) Applicant: Furukawa Electric Co., Ltd., Chiyoda-ku Tokyo 100-8322 (JP)
(72) Inventor: SAKAMOTO, Hisaki, Tokyo 100-8322 (JP); NAGASU, Yoshinori, Tokyo 100-8322 (JP)
(74) Representative: Horn Kleimann Waitzhofer
(86) International application number: PCT/JP2010/066757
(87) International publication number: WO 2011/040381

(57) **Abstract**

Disclosed is a low-cost metal substrate which is resistant to high-temperature oxidation, has excellent strength, is non-magnetic and is ideal for a high-temperature superconducting wire to be used at or lower than liquid nitrogen temperature. Austenitic stainless steel containing 0.4 weight% or more of nitrogen is used as the metal substrate for the superconducting wire. After heat treatment of 700 to 950°C in the high-temperature superconducting layer formation step is carried out, the metal substrate has an extremely high 0.2% proof stress at liquid nitrogen temperature.

## Description

### Technical Field

The present invention relates to a metal substrate for a superconducting wire for use in a superconducting instrument such as a superconducting cable and a superconducting magnet.

### Background Art

Heretofore, an RE-based superconductor (RE: rare earth element) has been known as a type of a high-temperature superconductor that exhibits superconductivity at a liquid nitrogen temperature (77K) or more. In particular, an yttrium-based superconductor represented by a chemical formula YBa₂Cu₃O_{7-y} (hereinafter, this is referred to as a Y-based super conductor or YBCO) is representative.
In general, a superconducting wire using the RE-based superconductor (hereinafter, this is referred to as an RE-based superconducting wire) has a stack structure in which, on a tape-like metal substrate, there are sequentially stacked an intermediate layer, a layer made of the RE-based superconductor (hereinafter, this is referred to as an RE-based superconducting layer), and a stabilizing layer.

In the RE-based superconducting wire, it is necessary that RE-based superconducting crystals be arrayed (biaxially oriented) as if being single crystals. Therefore, there have been proposed: a method of using, as a template to biaxially orient a superconducting layer, an oriented metal substrate using a recrystallization texture of face centered cubic (fcc) metal having such an fcc structure; and a method of depositing a forcibly oriented intermediate layer biaxially oriented with force by an ion beam assisted deposition (IBAD) method and the like.
In both of the methods, it is necessary that the metal substrate can be processed to a thickness of approximately 0.1 mm. In the former method, since it is necessary that the metal substrate itself be biaxially oriented, a Ni-based material, an Ag-based material, a Cu-based material or a composite material of these is used as a raw material thereof. Meanwhile, in the latter method, limitations about the orientation and the like are not imposed on the metal substrate, and basically, any metal substrate may be used as long as the metal substrate can endure such stacking of the intermediate layer and the superconducting layer.

Incidentally, in order to use the RE-based superconducting wire for an application instrument, the following conditions are required for a substrate for the RE-based superconducting wire, which are:
(1) that the RE-based superconducting wire formed of the substrate should have high strength;
(2) that the substrate should be nonmagnetic at a usage temperature; and
(3) that the substrate should have sufficient corrosion resistance under conditions of forming the intermediate layer and the superconducting layer.
In the method of using the forcibly oriented intermediate layer, it is frequent that a Hastelloy C276 alloy (Hastelloy is a registered trademark) which is nonmagnetic and excellent in high-temperature oxidation resistance (corrosion resistance) and strength is used as the metal substrate (for example, Patent Document 1).

### Prior Art Document

### Patent Document

Patent Document 1: Japanese Patent Laid-Open Publication No. 2001-266666
Patent Document 2: Japanese Patent Laid-Open Publication No. H11-302798
Patent Document 3: Japanese Patent Laid-Open Publication No. H08-269632

### Disclosure of the Invention

### Problem to be Solved by the Invention

However, since the Hastelloy C276 alloy uses large amounts of expensive elements such as Ni and W, the Hastelloy C276 alloy is extremely expensive (more expensive than ¥10, 000/kg), and this is a main factor to hinder a price drop of the RE-based superconducting wire.
In this connection, there is required an inexpensive metal substrate, which is nonmagnetic, and has equivalent high-temperature oxidation resistance and strength to those of the Hastelloy C276.
Note that austenitic stainless steel is known as a metal material, which is nonmagnetic, excellent in corrosion resistance, and capable of obtaining high strength, though it is unknown whether the austenitic stainless steel concerned satisfies the above-described properties required for the substrate for the superconducting wire (for example, refer to Patent Documents 2 and 3).

The present invention has been made in order to solve the above-described problem. It is an object of the present invention to provide an inexpensive metal substrate, which is suitable for use as a material for the high-temperature superconducting wire used at or lower than the liquid nitrogen temperature, is nonmagnetic, and is excellent in high-temperature oxidation resistance and strength. Means for Solving the Problems

The invention according to claim 1 is a substrate for a high-temperature superconducting wire used at or lower than a liquid nitrogen temperature,
wherein the substrate is made of austenitic stainless steel containing 0.4 weight% or more of nitrogen.

The invention according to claim 2 is the substrate for a superconducting wire according to claim 1, wherein the austenitic stainless steel contains 20 weight% or more of chromium.

The invention according to claim 3 is the substrate for a superconducting wire according to either one of claims 1 and 2, wherein the austenitic stainless steel contains 0. 05 weight% or less of carbon.

The invention according to claim 4 is the substrate for a superconducting wire according to any one of claims 1 to 3, wherein the austenitic stainless steel contains 5 weight% or more of manganese and 10 weight% or less of nickel.

The invention according to claim 5 is a superconducting wire which is formed by forming a superconducting layer on a substrate while interposing an intermediate layer in between, the substrate being made of austenitic stainless steel containing 0.4 weight% or more of nitrogen.

The invention according to claim 6 is the superconducting wire according to claim 5, wherein the austenitic stainless steel contains 20 weight% or more of chromium.

The invention according to claim 7 is the superconducting wire according to either one of claims 5 and 6, wherein the austenitic stainless steel contains 0.05 weight% or less of carbon.

The invention according to claim 8 is the superconducting wire according to any one of claims 5 to 7, wherein the austenitic stainless steel contains 5 weight% or more of manganese and 10 weight% or less of nickel.

The invention according to claim 9 is the superconducting wire according to any one of claims 5 to 8, wherein a 0.2% proof stress of the substrate at a liquid nitrogen temperature is 1200 MPa or more.

The invention according to claim 10 is a manufacturing method of a superconducting wire, comprising the steps of:
forming an intermediate layer on a substrate made of austenitic stainless steel containing 0.4 weight% or more of nitrogen and 0.05 weight% or less of carbon; and
forming a superconducting layer on the intermediate layer,
wherein heat treatment of 700 to 950°C is performed in either of the steps of forming the intermediate layer and the forming the superconducting layer.

It is publicly known that, as disclosed in Patent Documents 2 and 3, N (nitrogen) is useful for enhancing the strength of the superconducting substrate at the normal temperature. However, in Patent Document 2 or 3, it is not clearly described that the strength at the low temperature is held even after the material concerned of the superconducting wire is exposed to the high temperature in a manufacturing process thereof. In general, when metal is annealed at high temperature, dislocation thereof is released, and further, recrystallization thereof occurs. Accordingly, unless reaction is caused in the metal to generate a compound, the metal is softened to lower the strength of the superconducting wire.

The inventors of the present invention have focused attention to the austenitic stainless steel, which is less expensive than the Hastelloy C276, and is nonmagnetic. The inventors have repeated examinations so that the austenitic stainless steel can be applied to the substrate for a superconducting wire by optimizing component elements thereof. Then, the inventors have experimentally found out that the strength of the austenitic stainless steel at the low temperature is enhanced by adjusting the content of N therein. Moreover, the inventors have confirmed that desired strength is held even if the austenitic stainless steel is subjected to high-temperature heat treatment in the step of forming the superconducting layer. Furthermore, the inventors have found out that, by adjusting the contents of Ni (nickel), C (carbon), Mn (manganese) and Cr (chromium) in the austenitic stainless steel, the superconducting properties can be prevented from being lowered by the Ni diffusion from the metal substrate, and desired corrosion resistance can be realized.
As described above, the present invention has been completed based on the assiduous research by the inventors of the invention, and enables the austenitic stainless steel to be applied to the substrate for a superconducting wire by adjusting the content of N therein.

### Effect of the Invention

In accordance with the present invention, there is provided the inexpensive metal substrate, which is suitable for use as the material for the superconducting wire, is nonmagnetic, and is excellent in high-temperature oxidation resistance and strength. Then, the superconducting wire is manufactured by using this metal substrate, whereby price reduction of the superconducting wire can be achieved.

### Brief Description of the Drawings

FIG. 1 is a view showing a stack structure of a superconducting wire according to an embodiment.
FIG. 2 is a table showing component compositions of metal substrates according to an example and comparative examples.
FIG. 3 is a table showing results of evaluating properties of the metal substrates according to the example and the comparative examples.
FIG. 4 is a graph showing a relationship between an annealing temperature and substrate strength (0.2% proof stress).
FIG. 5 is a table showing component compositions of the metal substrates according to the example and the comparative examples and results of evaluating properties thereof. Mode for Carrying out the Invention

A description is made below in detail of an embodiment of the present invention.

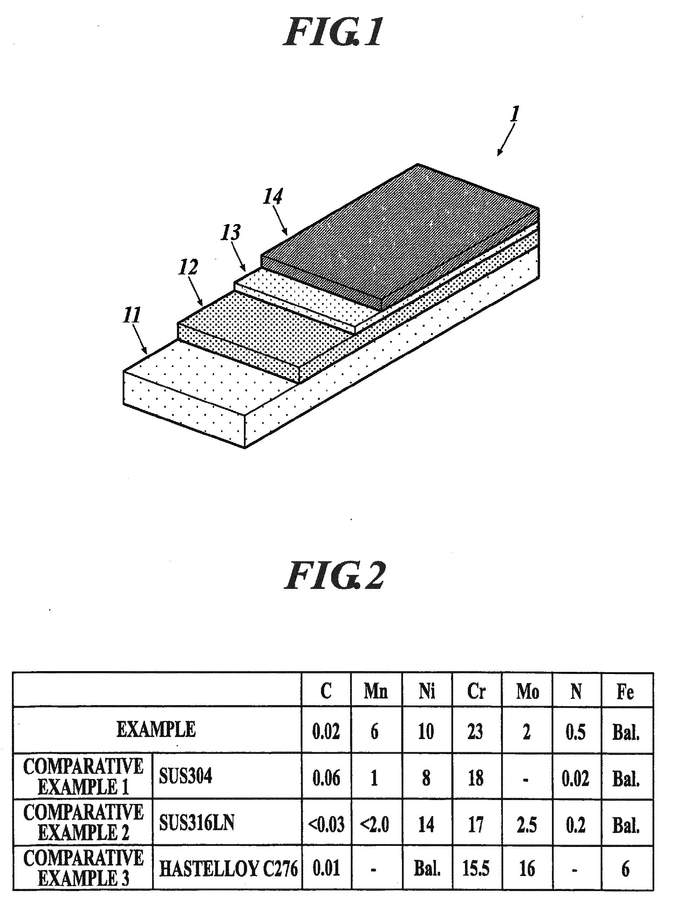

FIG. 1 is a view showing a stack structure of a superconducting wire according to this embodiment.
As shown in FIG. 1, a RE-based superconducting wire 1 has a stack structure in which an intermediate layer 12, a superconducting layer 13, and a stabilizing layer 14 are sequentially formed on a tape-like metal substrate 11.
In this embodiment, the metal substrate 11 is a non-oriented metal substrate made of nonmagnetic austenitic stainless steel. The intermediate layer 12 is composed by including a biaxially oriented layer (for example, GZO (Gd₂Zr₂O₇) for orienting crystals of the superconducting layer 13 in fixed directions. This biaxially oriented layer is formed, for example, by an IBAD method.
The superconducting layer 13 is an Y-based superconducting layer made of an Y-based superconductor, and is deposited, for example, by a metal organic chemical vapor deposition (MOCVD) method. On an upper surface of the superconducting layer 13, the stabilizing layer 14 made of silver is deposited, for example, by a sputtering method.

In this embodiment, the metal substrate 11 has a following composition. That is to say, the metal substrate 11 is made of austenitic stainless steel having a component composition, which is:
N: 0.4 weight% or more;
Ni: 10 weight% or less;
C: 0.05 weight% or less;
Mn: 5 weight% or more;
Cr: 20 weight% or more; and
as residues, Fe and inevitable impurities.
Critical current properties of the superconducting wire 1 are lowered by a magnetic field, and accordingly, the nonmagnetic austenitic stainless steel is used as the metal substrate 11. Moreover, the metal substrate 11 may contain Al, Si, Mo and the like, which are component elements of the general austenitic stainless steel.

N is an interstitial atom, and enhances strength and corrosion resistance of the metal substrate 11. When such a content of N in the metal substrate is smaller than 0. 4 weight%, desired strength and corrosion resistance cannot be realized. Accordingly, the content of N is set at 0.4 weight% or more. Note that, when the content of N is larger than 1.5 weight%, it is difficult to suppress blowholes at the time when the components are coagulated, and it is difficult to process the components into the substrate. Therefore, it is desirable that the content of N be set at 1.5 weight% or less.
In such a way, the metal substrate 11 comes to have desired strength at a low temperature, specifically, comes to have strength equivalent to that of the Hastelloy C276 or more at a low temperature. Hence, the metal substrate 11 is suitable as a substrate for the superconducting wire used at or lower than a liquid nitrogen temperature (77K). Moreover, in the case where the superconducting wire 13 is deposited by the MOCVD method in a manufacturing process of the superconducting wire 1, the superconducting wire 1 is heated up to approximately 800°C; however, even in such a case, the strength at the low temperature is held.
Furthermore, by the fact that the strength of the metal substrate 11 is high, a defect such as peeling can be prevented from occurring after the intermediate layer 12 and the superconducting layer 13 are deposited, and the critical current properties of the superconducting wire 1 can be enhanced.

When such a content of Ni in the metal substrate 11 is larger than 10 weight%, a possibility that Ni diffusion from the metal substrate 11 may reach the superconducting layer 13 is increased. Therefore, it is desirable that the content of Ni be set at 10 weight% or less.
In such a way, the Ni diffusion from the metal substrate 11 can be reduced. Accordingly, the lowering of the superconducting properties due to the fact that the Ni diffusion reaches the superconducting layer 13 can be relieved. Note that Ni is useful for stabilizing an austenite phase and enhancing processability thereof, and it is desirable that the content of Ni be set at 7 weight% or more in order to enjoy this effect.

When such a content of C in the metal substrate 11 is larger than 0.05 weight%, Cr carbide becomes prone to be generated at a high temperature (for example, 700 to 950°C as a heat treatment temperature in a forming step of the superconducting layer 13) . Therefore, it is desirable that the content of C be set at 0.05 weight% or less.
In such a way, the Cr carbide can be suppressed from being generated at the high temperature. Accordingly, the corrosion resistance of the superconducting wire 1 can be prevented from being lowered by reduction of an amount of solid-solved Cr. Note that, though C is useful for enhancing the strength in general, C is prone to lower ductility of the superconducting wire at the liquid nitrogen temperature as a usage temperature thereof or less. Accordingly, a smaller loading amount of C is preferable.

When such a content of Mn in the metal substrate 11 is smaller than 5 weight%, the effects of stabilizing the austenite phase and increasing a solid solution amount of N do not appear significantly. Accordingly, it is desirable that the content of Mn be set at 5 weight% or more. Meanwhile, when the content of Mn is larger than 10 weight%, hot processability of the substrate is lowered, and this makes it difficult to process the substrate concerned. Therefore, it is more preferable that the content of Mn be set at 10 weight% or less. Moreover, when the content of Mn is increased, the austenite phase can be stabilized even if the content of Ni is reduced by that amount. Hence, since the content of Ni can be reduced, the Ni diffusion can be reduced more effectively.

When such a content of Cr in the metal substrate 11 is smaller than 20 weight%, the desired corrosion resistance cannot be realized. Therefore, it is desirable that the content of Cr be set at 20 weight% or more.
In such a way, the corrosion resistance of the superconducting wire 1 can be enhanced. Note that the content of Cr in the austenitic stainless steel is set at preferably 30 weight% or less, more preferably at 25 weight%. A reason for this is as follows. When the content of Cr becomes 30 weight% or more, Cr is not perfectly solid-solved and becomes Cr nitride, and this not only reduces the added N but also thereby deteriorates the corrosion resistance, fatigue strength, ductility and tractility, and further, significantly deteriorates the heat processability.

Note that the generation of the chromium carbide by the carbon in the steel is significantly expressed in a temperature range of 650°C to 950°C, and it is said that the chromium carbide is decomposed and solid-solved one more time by being heated to 1100 to 1200°C or more though this temperature differs depending on the composition. In the superconducting wire 1, the temperature thereof becomes approximately 700°C in the deposition of the intermediate layer 12, and becomes approximately 850°C in the deposition of the superconducting layer 13. Accordingly, the superconducting wire 1 comes to stay in a temperature where the chromium carbide is generated.
Therefore, when a large amount of the carbon is present in the metal substrate 1, a large amount of the chromium carbide is generated, whereby Cr that should form a passivation film falls short, and a strong passivation film is not formed. Therefore, it becomes impossible to suppress emersion of abnormal oxidation on the surface of the metal substrate 11 owing to the nickel and the like, and the diffusion of the nickel and the like from the metal substrate 11 to the superconducting layer 13.

Meanwhile, in the case where the amount of carbon in the metal substrate 11 is small, the chromium carbide is less likely to be generated, a strong passivation film made of Cr₂O₃ or the like is formed on the surface of the metal substrate 11. Therefore, in both of the cases of depositing the intermediate layer 12 and the superconducting layer 13, even if oxygen supplied at the time of the deposition passes through the intermediate layer 12 and the like and is diffused onto the surface of the metal substrate 11, rapid oxidation on the surface of the metal substrate 11 can be suppressed by the passivation film. Furthermore, the diffusion of the nickel and the like from the metal substrate 11 to the superconducting layer 13 can also be suppressed by the passivation film.

### [Example]

In Example, stainless steel having a composition (weight%) shown in FIG. 2 was used as a material of the substrate. That is to say, the material of the substrate is the austenitic stainless steel having the component composition, which is: C: 0.02 weight%; Mn: 6 weight%; Ni: 10 weight%; Cr: 23 weight%; Mo: 2 weight%; N: 0.5 weight%; and as residues, Fe and inevitable impurities.
This austenitic stainless steel was appropriately subjected to intermediate annealing, and was rolled to a thickness of 0.1 mm. Then, the austenitic stainless steel thus rolled was slit to be thereby formed into pieces with a width of 10 mm, and each of the pieces was used as the metal substrate 11.
This metal substrate 11 was subjected to surface polishing, and thereafter, a GZO layer (biaxially oriented layer) was deposited thereon to a thickness of 1 µm by the IBAD method at a normal temperature. Moreover, on the GZO layer, a CeO₂ layer (cap layer) was deposited to a thickness of 500 nm by the sputtering method at a heating temperature of 700°C. That is to say, in Example, the intermediate layer 12 was composed of the GZO layer and the CeO₂ layer.
Then, on the intermediate layer 12, the Y-based superconducting layer 13 was deposited to a thickness of 1 µm by the MOCVD method at a heating temperature of 850°C. Moreover, on the Y-based superconducting layer 13, an Ag protection layer was appropriately deposited, and was subjected to oxygen annealing at 550°C in a flow of oxygen.

### [Comparative examples]

In Comparative examples 1 to 3, as materials of the respective substrates, SUS304 (general-purpose austenitic stainless steel, 18Cr-8Ni-0.06C), SUS316LN (18Cr-12Ni-2Mo-N-0.02C) and the Hastelloy C276 were used, and superconducting wires were fabricated in a similar way to Example. Note that compositions of the respective substrate materials are as shown in FIG. 2, and such steel type names are designations in JIS.

For the superconducting wires fabricated in Example 1 and Comparative examples 1 to 3, critical currents were measured at a voltage definition of 1 µV/cm by the four-terminal method in liquid nitrogen. Moreover, for the superconducting wires, a tensile test was performed at a room temperature and the liquid nitrogen temperature (77K), and 0.2% proof stresses were measured. Note that, with regard to the 0.2% proof stresses of the superconducting wires, after the superconducting layers 13 were deposited, the intermediate layers 12 and the superconducting wires 13 were peeled off, the tensile test was performed only for the metal substrates 11, and the 0.2% proof stresses were measured. With regard to the high-temperature oxidation resistance (corrosion resistance), after the intermediate layers 12 and the superconducting layers 13 were stacked, peeling observation in the superconducting layers 13 was performed, and the high-temperature oxidation resistance was determined based on whether or not the peeling occurred.

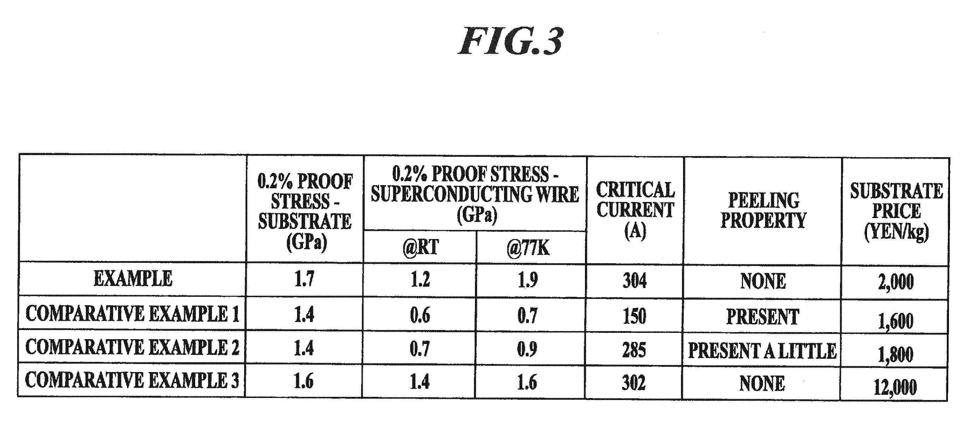

Evaluation results are shown in FIG. 3. FIG. 3 also shows strengths (0.2% proof stresses at the room temperature) of simple bodies of the metal substrates for reference.
As shown in FIG. 3, the superconducting wire according to Example had critical current properties equivalent to those of the superconducting wire according to Comparative example 3, which used the Hastelloy C276 as the substrate. Moreover, in the superconducting wire according to Example, the 0.2% proof stress thereof at the room temperature was approximately 70 to 80% of that of the superconducting wire according to Comparative example 3; however, the 0.2% proof stress thereof at 77K exhibited a higher value than that of the superconducting wire according to Comparative example 3. It is considered that there appears the effect of enhancing the strength by N (nitrogen). In each of Example and Comparative example 3, the high-temperature oxidation resistance obtained by the peeling observation after the deposition of the superconducting layer was good.
Moreover, the superconducting wire according to Example was superior in the critical current properties and the high-temperature oxidation resistance to Comparative examples 1 and 2 using, as the substrate, the austenitic stainless steel in the same price range, and was largely superior thereto in the strength.

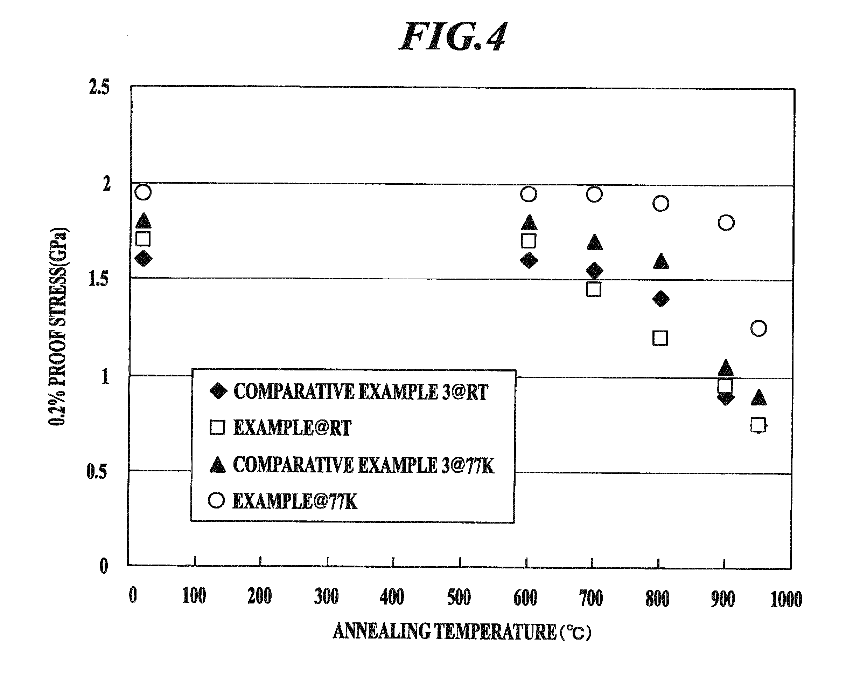

Moreover, in order to confirm the strengths of the substrates themselves, for the substrate material used in Example and the Hastelloy C276 used in Comparative example 3, the annealing was performed, and thereafter, the tensile test was performed at the room temperature and the liquid nitrogen temperature (77K). Note that an annealing time was set at 30 minutes.
Test results are shown in FIG. 4. As shown in FIG. 4, the strengths of the substrate material used in Example and of the Hastelloy C276 were substantially equivalent to each other just after the substrate material and the Hastelloy C276 were rolled. When the annealing temperature was raised, the strength of the substrate material of Example at the room temperature was lowered than that of the Hastelloy C276; however, the strength thereof at the temperature as low as 77K, which was the usage temperature, was rather higher than that of the Hastelloy C276. Specifically, in the substrate material according to Example, the 0.2% proof stress thereof at the liquid nitrogen temperature after the substrate material concerned was subjected to the heat treatment of 700 to 950°C became 1200 MPa or more.
In such a way, it was understood that, under such a special usage environment of the metal substrate for the superconducting wire, where the metal substrate concerned is used at the low temperature after being annealed at the high temperature, the substrate material used in Example is superior to the Hastelloy C276 in terms of the strength.

When it is considered that a price of the substrate material used in Example is 1/6 of that of the Hastelloy C276, it is understood that the substrate material concerned is extremely effective for achieving price reduction of the superconducting wire. As described above, in accordance with the substrate material used in Example 1, a superconducting wire was able to be realized, which was excellent in the corrosion resistance and had a high critical current though was inexpensive.

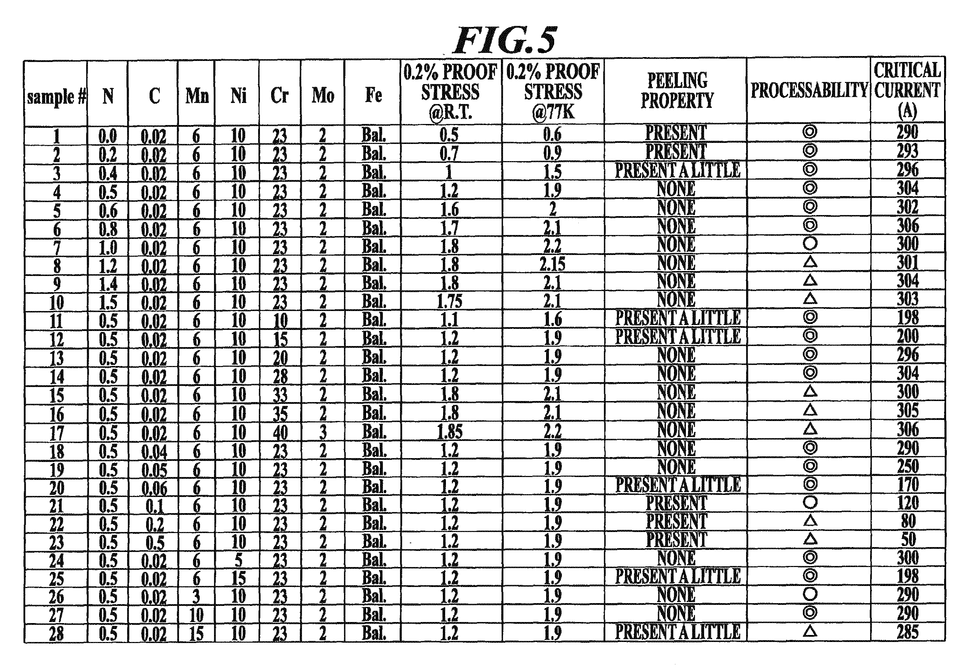

In a similar way to Example described above, each piece of stainless steel, which had a composition (weight%) shown in FIG. 5, was used as the substrate material, and property evaluation similar to that of Example described above and processability evaluation were performed. Note that, with regard to the processability evaluation, the processability was determined based on how a base material turned at the time of being processed to a thickness of 0.1 mmt. In the case where such a sample was processable without any defect, the sample was evaluated as a mark of "DOUBLE CIRCLE". In the case where such a sample was processable substantially without the defect, the sample was evaluated as a mark of "SINGLE CIRCLE". In the case where such a sample was processable though disconnection and the like occurred and there were many defects, the sample was evaluated as a mark of "TRIANGLE". In the case where such a sample was not processable to 0.1 mmt, the sample was evaluated as a mark of "CROSS".

In each of Samples 1 to 10, a composition was composed so that the content of nitrogen in the austenitic stainless steel could be 0 to 1.5 weight%.
From results in FIG. 5, it is understood that, in the case where the content of nitrogen is less than 0.4 weight%, the corrosion resistance is a little poorer than that in the case where the content of nitrogen is 0.4 weight% or more. Meanwhile, in the case where the content of nitrogen is 0.4 weight% or more to 1.5% or less, each of such samples has the desired corrosion resistance, and this is preferable. Moreover, in the case where the content of nitrogen is 0.5 weight% or more and 1.0 weight% or less, it is understood that a desired value or more can be obtained as critical current (Ic) in the superconducting wire using the substrate, and that this is more preferable.
Note that, in the case where the content of nitrogen is larger than 1.5 weight%, it is difficult to process the substrate material into the substrate; however, austenitic stainless steel containing high-concentration nitrogen can be formed, for example, by using solid solution nitriding. The solid solution nitriding is a type of chemical-thermal treatment method for achieving a nitrogen increase in the vicinity of the material surface or in the entirety of the material in such a manner that steel is held in high-temperature nitrogen gas of 1000°C or more, and that nitrogen atoms are thereby diffused from the material surface to a solid phase (austenite phase).

In each of Samples 4 and 11 to 17, a composition was composed so that the content of chromium in the austenitic stainless steel could be 10 to 40 weight%.
It is understood that, in the case where the content of chromium is less than 20 weight% (Samples 11 and 12), the corrosion resistance is a little poorer than that in the case where the content of chromium is 20 weight% or more (Samples 4 and 13 to 17). Meanwhile, it is understood that, in the case where the content of chromium is larger than 30 weight% (Samples 15 to 17), the processability is poorer than that in the case where the content of chromium is 30 weight% or less (Samples 4 and 11 to 14).
Hence, the case where the content of chromium is 20 weight% or more to 30 weight% or less is the most preferable.

In each of Samples 4 and 18 to 23, a composition was composed so that the content of carbon in the austenitic stainless steel could be 0.02 to 0.5 weight%.
The following is understood: in the case where the content of carbon is 0.05 weight% or less (Samples 14, 17 and 18), each sample has the desired corrosion resistance, and also has a comparatively high value of critical current (Ic); however, in the case where the content of carbon exceeds 0.05 weight% (Samples 19 to 23), the corrosion resistance thereof is poorer, and critical current(Ic) is also lower than those in Samples 4, 17 and 18. This is considered to be because, since many peeled spots are recognized in the superconducting layer, critical current (Ic) is lowered by the peeling.
It is considered that this peeling occurs since local oxidation by Ni and the like in the substrate is caused because, by the heating in the event of depositing the superconducting layer, Cr and C in the substrate react with each other to generate a precipitate such as Cr₂₃C₆, effective Cr elements in the substrate are reduced, and the formation of the passivation film such as Cr₂O₃ becomes insufficient.
Hence, it is preferable that the content of carbon in the austenitic stainless steel be 0.05 weight% or less.

In each of Samples 4, 24 and 25, a composition was composed so that the content of nickel in the austenitic stainless steel could be 5 to 15 weight%.
In comparison with the case where the content of nickel is 10 weight% or less (Samples 4 and 24), in Sample 25 of the case where the content of nickel is 15 weight%, the corrosion resistance is a little poorer, and critical current (Ic) is also low. This is considered to be because, since a concentration of the nickel contained in the austenitic stainless steel is high, the nickel diffusion is caused up to the superconducting layer.
Hence, it is preferable that the content of nickel in the austenitic stainless steel be 10 weight% or less.

In each of Samples 4 and 26 to 28, a composition was composed so that the content of manganese in the austenitic stainless steel could be 6 to 15 weight%.
In comparison with the case where the content of manganese is 5 to 10 weight% (Samples 4 and 27), in Sample 26 where the content of manganese is less than 5 weight%, the processability is deteriorated a little. This is because the steel becomes unstable since the solid solution amount of nitrogen in the austenitic stainless steel is reduced. Moreover, it is understood that, in Sample 28 where the content of manganese exceeds 10 weight%, the processability is deteriorated, and further, that the corrosion resistance is also lowered a little.
Hence, it is preferable that the content of manganese in the austenitic stainless steel be 5 weight% or more to 10 weight% or less.

The description has been specifically made above of the present invention, which has been made by the inventors of the present invention, based on the embodiment; however, the present invention is not limited to the above-described embodiment, and is alterable within the scope without departing from the spirit thereof.
It should be considered that, in all aspects, the embodiment disclosed this time is illustrative and is not restrictive. The scope of the present invention is indicated not by the above description but by the scope of claims, and all changes within the equivalent meaning and scope to the scope of claims are intended to be incorporated therein.

### Explanation of Reference Numerals

- 1: SUPERCONDUCTING WIRE
- 11: METAL SUBSTRATE (AUSTENITIC STAINLESS STEEL)
- 12: FORCIBLY ORIENTED INTERMEDIATE LAYER
- 13: Y-BASED SUPERCONDUCTING LAYER
- 14: STABILIZING LAYER

## Claims

1. A substrate for a high-temperature superconducting wire used at or lower than a liquid nitrogen temperature,
wherein the substrate is made of austenitic stainless steel containing 0.4 weight% or more of nitrogen.

2. The substrate for a superconducting wire according to claim 1, wherein the austenitic stainless steel contains 20 weight% or more of chromium.

3. The substrate for a superconducting wire according to either one of claims 1 and 2, wherein the austenitic stainless steel contains 0.05 weight% or less of carbon.

4. The substrate for a superconducting wire according to any one of claims 1 to 3, wherein the austenitic stainless steel contains 5 weight% or more of manganese and 10 weight% or less of nickel.

5. A superconducting wire which is formed by forming a superconducting layer on a substrate while interposing an intermediate layer in between, the substrate being made of austenitic stainless steel containing 0.4 weight% or more of nitrogen.

6. The superconducting wire according to claim 5, wherein the austenitic stainless steel contains 20 weight% or more of chromium.

7. The superconducting wire according to either one of claims 5 and 6, wherein the austenitic stainless steel contains 0.05 weight% or less of carbon.

8. The superconducting wire according to any one of claims 5 to 7, wherein the austenitic stainless steel contains 5 weight% or more of manganese and 10 weight% or less of nickel.

9. The superconducting wire according to any one of claims 5 to 8, wherein a 0.2% proof stress of the substrate at a liquid nitrogen temperature is 1200 MPa or more.

10. A manufacturing method of a superconducting wire, comprising the steps of:
forming an intermediate layer on a substrate made of austenitic stainless steel containing 0.4 weight% or more of nitrogen and 0.05 weight% or less of carbon; and
forming a superconducting layer on the intermediate layer,
wherein heat treatment of 700 to 950°C is performed in either of the steps of forming the intermediate layer and the forming the superconducting layer.
